# EUROPEAN PATENT SPECIFICATION

(11) **EP 0 790 762 B1**
(45) Date of publication and mention of the grant of the patent: **08.10.2003**
(21) Application number: 96309194.7
(22) Date of filing: 17.12.1996
(51) Int. Cl.: H05K 7/20, B32B 5/16

(54) **Conductive cooling of a heat-generating electronic component**
Kühlung durch Wärmeableitung für einen wärmeerzeugenden elektronischen Teil
Refroidissement par conductivité pour un élément électronique thermogène

(30) Priority: 30.01.1996 US 10830
(43) Date of publication of application: 20.08.1997
(73) Proprietor: PARKER HANNIFIN CORPORATION, Cleveland Ohio 44112 (US)
(72) Inventor: De Sorgo, Miksa, Windham, New Hampshire 33087 (US)
(74) Representative: Pilch, Adam John Michael

(56) References cited:
- US-A- 4 782 893
- US-A- 4 869 954
- US-A- 5 137 959
- US-A- 5 194 480
- US-A- 5 213 868

## Description

The present invention relates to conductive cooling of heat-generating electronic components.

Circuit designs for modern electronic devices such as televisions, radios, computers, medical instruments, business machines, communications equipment, and the like have become increasingly complex. For example, integrated circuits have been manufactured for these and other devices which contain the equivalent of hundreds of thousands of transistors. Although the complexity of the designs has increased, the size of the devices has continued to shrink with improvements in the ability to manufacture smaller electronic components and to pack more of these components in an ever smaller area.

As electronic components have become smaller and more densely packed on integrated boards and chips, designers and manufacturers now are faced with the challenge of how to dissipate the heat which is ohmicly or otherwise generated by these components. Indeed, it is well known that many electronic components, and especially semiconductor components such as transistors, are more prone to failure or malfunction at high temperatures. Thus, the ability to dissipate heat often is a limiting factor on the performance of the component.

Electronic components, such as integrated circuits, of electronic devices traditionally have been cooled via forced or convective circulation of air within a housing of the device. In this regard, cooling fins have been provided as an integral part of the component package or separately attached thereto to increase the surface area of the package exposed to convectively-developed air currents. Electric fans additionally have been employed to increase the volume of air which is circulated within the housing. For high power circuits and the smaller but more densely packed circuits typical of current electronic designs, however, simple air circulation often has been found to be insufficient adequately to cool the circuit components.

As is described in patent specifications US-A-4,965,699 and US-A-4,266,267, heat dissipation beyond that which is attainable by simple air circulation may be effected by the direct mounting of the electronic component to a "cold plate" or other heat sink. The heat sink may be a dedicated, thermally-conductive metal plate, or simply the chassis of the device. However, inasmuch as the chassis of the device generally is provided to be at ground potential, it is necessary electrically to insulate the electrical component from the chassis or other substrate to prevent shorting. In this regard, electrically-insulating, thermally-conductive interface materials have been employed between the electrical component and the heat sink. These interface materials may be compounded as containing one or more thermally-conductive particulate fillers dispersed within a polymeric binder, and may be provided in the form of cured sheets, tapes, pads, or films, or as adhesives or greases such as silicone grease. Typically binder materials include silicones, urethanes, thermoplastic rubbers, and other elastomers, with typical fillers including aluminum oxide, magnesium oxide, zinc oxide, boron nitride, and aluminum nitride.

Exemplary of the aforesaid interface materials is a boron-nitride filled silicone elastomer which is marketed under the name CHO-THERM® by the Chomerics Division of Parker-Hannifin Corp., Woburn, MA. Additionally, patent specification US-A-4,869,954 discloses a cured, form stable, sheet-like, thermally-conductive material for transferring thermal energy. The material is formed of a urethane binder, a curing agent, and one or more thermally conductive fillers. The fillers, which may include aluminum oxide, aluminum nitride, boron nitride, magnesium oxide, or zinc oxide, preferably are provided in a particle sizes ranging from about 1-50 microns (0.05-2 mils).

Patent specification US-A-4,764,845 discloses a thermally-cooled electronic assembly which includes a housing containing electronic components. A heat sink material fills the housing in direct contact with the electronic components for conducting heat therefrom. The heat sink material comprises a paste-like mixture of particulate microcrystalline material such as diamond, boron nitride, or sapphire, and a filler material such as a fluorocarbon or paraffin. The particle size distribution and packing of the heat sink material into the housing is such as to provide a mean particle to particle distance of 0.004 mils (0.1 microns).

Patent specification US-A-4,782,893 discloses a thermally-conductive, electrically-insulative pad for placement between an electronic component and its support frame. The pad is formed of a high dielectric strength material in which id dispersed diamond powder. In this regard, the diamond powder and a liquid phase of the high dielectric strength material may be mixed and then formed into a film and cured. In one embodiment, the diamond is provided as having a particle size which is the same or slightly greater than the thickness of the film. After the film is formed, a thin layer thereof is removed by chemical etching or the like to expose the tips of the diamond particles. A thin boundary layer of copper or other metal then is bonded to the top and bottom surfaces of the film such that the exposed diamond tips extend into the surfaces to provide pure diamond heat transfer paths across the film. The pad may be joined to the electronic component and the frame with solder or an adhesive.

Patent specification US-A-4,965,699 discloses a printed circuit device which includes a memory chip mounted on a printed circuit card. The card is separated from an associated cold plate by a layer of uncured silicone elastomer which is applied to the surface of the cold plate.

Patent specification US-A-4,974,119 discloses a heat sink assembly which includes an electronic component supported on a printed circuit board in a spaced-apart relationship from a heat dispersive member. A thermally-conductive, elastomeric layer is interposed between the board and the electronic component. The elastomeric member may be formed of silicone and preferably includes a filler such as aluminum oxide or boron nitride.

Patent specification US-A-4,979,074 discloses a printed circuit board device which includes a circuit board which is separated from a thermally-conductive plate by a pre-moulded sheet of silicone rubber. The sheet may be loaded with a filler such as alumina or boron nitride.

Patent specification US-A-5,137,959 discloses a thermally-conductive, electrically insulating interface material comprising a thermoplastic or cross linked elastomer filled with hexagonal boron nitride or alumina having an average particle size diameter of from about 2-50 microns (0.08-2mils). The material may be formed as a mixture of elastomer and filler, which then may be cast or moulded into a sheet or other form.

Patent specification US-A-5,194,480 discloses another thermally-conductive, electrically-insulating filled elastomer. A preferred filler is hexagonal boron nitride having a particle size of from about 5-200 microns (2-8 mils). The filled elastomer may be formed into blocks, sheets, or films using conventional methods.

Patent specifications US-A-5,213,868 and US-A-5,298,791 disclose a thermally-conductive interface material formed of a polymeric binder and one or more thermally-conductive fillers. the fillers may be particulate solids, such as aluminum oxide, aluminum nitride, boron nitride, magnesium oxide, or zinc oxide, having a particle size of about 1-50 microns (0.05-2 mils). The material may be formed by casting or moulding, and preferably is provided as a laminated acrylic pressure sensitive adhesive (PSA) tape. At least one surface of the tape is provided as having channels or through-holes formed therein for the removal of air from between that surface and the surface of a substrate such as a heat sink or an electronic component.

Patent specification US-A-5,321,582 discloses an electronic component heat sink assembly which includes a thermally-conductive laminate formed of polyamide which underlays a layer of a boron nitride-filled silicone. The laminate is interposed between the electronic component and the housing of the assembly.

As the above-described composition shave garnered acceptance for use as interface materials in conductively-cooled electronic component assemblies, it will be appreciated that further improvements in these materials and in the methods of fabricating assemblies of the same would be well-received by the electronics industry. Especially desired would be a composition which could be easily and economically applied in a fluent state directly to a circuit board, heat sink, circuit board, or the like, and then cured-in-place to provide a thermally-conductive, electrically-insulating interface material exhibiting optimum heat transfer properties.

According to one aspect of the invention there is provided a method of conductively cooling a heat-generating electronic component disposable in spaced-apart adjacency with a surface of a thermal dissipation member to define a gap of predetermined width therebetween, said method comprising the steps of:
(a) providing a curable composition comprising an electrically-insulating polymeric binder having thermally-conductive, electrically-insulating filler particles dispersed therein, at least a portion of said particles being of a maximum average diameter about equal to the predetermined width of the gap,
(b) providing a layer of said composition disposable in conductive heat transfer contact with the electronic component and the surface of the thermal dissipation member, and
(c) curing said layer of said composition to form an interlayer within the gap, at least a portion of said filler particles of said maximum average diameter each substantially directly contacting the electronic component and the surface of the thermal dissipation member to establish thermally-conductive pathways effective to transfer heat from the electronic component to the heat dissipation member.

According to another aspect of the invention there is provided a conductively-cooled electrical assembly comprising:
a thermal dissipation member having an outer surface;
a heat-generating electronic component disposed in spaced-apart adjacency with said surface of said thermal dissipation member to define a gap of predetermined width therebetween; and
a cured-in-place interlayer disposed within said gap in conductive heat transfer contact with said electronic component and the surface of said thermal dissipation member, said interlayer comprising an electrically-insulating polymeric binder with thermally-conductive, electrically-insulating filler particles dispersed therein, at least a portion of said particles being of a maximum average diameter about equal to the predetermined width of the gap and substantially directly contacting said electronic component and the surface of said thermal dissipation member to establish heat transfer pathways from said electronic component to said thermal dissipation member.

Since the fillers particles are selected such that at least a portion thereof are of a maximum average diameter which is about equal to the width of the gap, substantially direct contact is facilitated between the electronic component and the thermal dissipation member thereby to establish thermally-conductive pathways for improved transfer heat from the component to the heat dissipation member.

The curable composition may be applied in a fluent state to a surface of the electrical component or thermal dissipation member, and then cured-in-place on that surface or interposed between the component and the dissipation member to form a thermally-conductive, electrically-insulating interlayer exhibiting improved heat transfer properties.

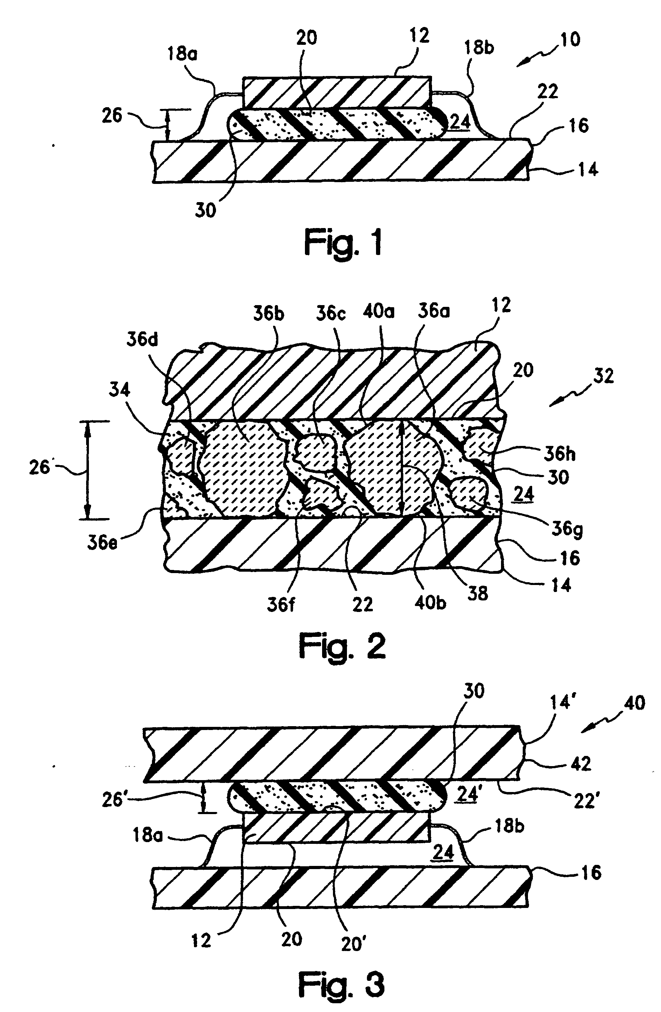

The invention is diagrammatically illustrated by way of example in the accompanying drawings, in which:-
Figure 1 is a fragmentary, cross-sectional view of an electrical assembly wherein an electronic component thereof can be conductively cooled in accordance with the present invention via the provision of an interlayer of a thermally-conductive, electrically-insulating curable composition between the component and an associated circuit board;
Figure 2 is a cross-sectional view of a portion of the electrical assembly of Figure 1 which is enlarged to detail the internal morphology of the interlayer composition of the present invention; and
Figure 3 is a fragmentary, cross-sectional view of an alternative embodiment of a conductively-cooled electrically assembly in accordance with the present invention wherein the thermally-conductive, electrically-insulating interlayer of Figure 1 is interposed between the electrical component and an associated heat sink.

Referring to the drawings wherein corresponding reference characters indicate corresponding elements throughout the figures, shown generally at 10 in figure 1 is an electrical assembly which includes a heat-generating, digital or analog electronic component, 12, disposed on an associated thermal dissipation member, 14. the thermal dissipation member 14 has a heat capacity relative to that of the component 12 to be effective in dissipating thermal energy transferred from the component 12. For the purposes of the present illustration, the thermal dissipation member 14 is shown as a printed circuit board or other substrate, 16, which supports the component 12 and separates it from other electronic components (not shown). The electrical component 12 may be an integrated microchip, transistor, or other semiconductor, or an ohmic or other heat-generating subassembly such as a diode, relay, resistor, transformer, amplifier, diac, or capacitor. For the electrical connection of the component 12 to the board 16, a pair of leads or pins, 18a and 18b, are provided as extending rom either end of the component 12 into a soldered or other connection with the board 16. The leads 18 additionally support the component 12 above the board 16 such that an external heat transfer surface, 20, of the component 12 is spaced-apart from an opposing surface, 22, of the board 16. A gap, represented at 24 as being of a predetermined width, 26, is thereby defined between the component 12 and the board 16. For most circuit board applications, the gap width 26 typically will be about 3 mils (75 microns).

A thermally-conductive, electrically-insulating interlayer, 30, is disposed within the gap 24 in conductive heat transfer contact with the surface 20 of the component 12 and the opposing surface 22 of the board 16. The interlayer 30 at least partially fills the gap 24 to provide a conductive path therethrough for the transfer of thermal energy from the component 12 to the board 16. Such path may be employed without or in conjunction with convective air circulation to effect the cooling of the component 12 and ensuring that the operating temperature thereof is maintained below specified limits.

Referring next to Figure 2, the internal morphology of the interlayer 30 is revealed generally at 32. In general composition, the interlayer 12 is formed of continuous phase of an electrically-insulating, cured polymeric binder or matrix, 34, within which is dispersed a plurality of thermally-conductive, electrically-insulating filler particles 36a-h. The filler particles 36 may be of a substantially uniform size or, as is shown, as having a distribution which includes a range of particles sizes. In whatever form provided, however, at least a portion of the filler particles 36, represented by filler particles 36a-b, is provided to be of a maximum average diameter or diametric extent, shown at 38. which is about equal to the predetermined width 26 of the gap 24. Where the particles 36 are provided as of a uniformly graded size, substantially all of the particles will be of the specified maximum average diameter. Alternatively, where the particles 36 are provided as having a size distribution, a portion of the particles representing the maximum average diameter of the population will be of the specified maximum average diameter.

As is represented again by the filler particles 36a-b, at least a portion of those filler particles 36 having the specified dimension each are made independently within the interlayer 30 substantially directly to contact the surface 20 of the component 12 and the opposing surface 22 of the board 16. That is, with reference to particle 36a, a first end, 40a, of the particle contacts the surface 20 of the component 12, with a corresponding second end, 40b, of the particle contacting the surface 22 of the board 16. In this way, thermally-conductive pathways are established directly through the particles 36a-b to transfer heat from the component 12 to the board 16. As the filler particles 36 may be characterized as exhibiting thermal conductivities which are higher than those associated with the continuous polymeric binder phase 34, it will be appreciated that the interlayer 30 exhibits heat transfer and other thermal properties which are improved as compared to the interface materials heretofore representative of the state of the art. For example, higher bulk thermal conductivities may be realized at lower filler loadings.

The polymeric binder 34 may be a thermosetting or thermoplastic material, and may be selected from a variety of commercially-available resins and elastomers such as polyurethanes, polyimides, nylons, polyamides, polyesters, epoxies, polyolefins, polyetheretherketones, silicones, fluorosilicones, thermoplastic elastomers, acrylics, and copolymers and blends thereof. However, owing to their excellent thermal and electrical properties, silicone resins and elastomers, which may be one- or two-part systems that are room temperature vulcanizing (RTV) in the presence of a curing agent or catalyst, or that are photoinitiated or moisture cured, are to be considered preferred.

Thermally-conductive, electrically-insulating particulate solids suitable for use as the filler particles 36 include boron nitride, aluminum oxide, aluminum nitride, magnesium oxide, zinc oxide, silicon carbide, beryllium oxide, and mixtures thereof. As aforementioned, the filler particles 36 are provided as having a average particle size or maximum average size distribution selected relative to the width 26 of the gap 24 to be substantially equal thereto. For example, with the width 26 being given as about 3 mils (75 microns), the corresponding average particle or maximum average size distribution of the filler 36 will be about 3 mils (75 microns). Likewise, with the width 26 being given as about 5 mils (125 microns), the corresponding average particle or maximum average size distribution of the filler 36 will be about 5 mils (125). In contrast, most of the interface materials hereto known in the art, lacking controlled particle size distribution, have typical particle size distributions which range from about 1-1.5 mils (25-40 microns). Although there is no theoretical upper limit for either the width 25 of the gap 24, or the particle size or diametric extent 38 of the filler 36, a practical upper limit of about 8-10 mils (200-250 microns) may be realized depending upon the size availability of the selected filler, and on the limitations of the processing equipment available for compounding and delivery of the material.

The filler 36 is to be included within the polymeric binder 34 in a proportion sufficient to provide the thermal conductivity desired for the intended application. In this regard, inasmuch as there are established direct heat transfer paths through individual filler particles, the bulk thermal conductivity of the interlayer 30 is generally proportional to the filler density. For typical applications, the interlayer 30 may be provided as including about 50-55% by weight, corresponding to about 30% by volume, of the filler 36.

Additional fillers and additives may be included in the interlayer 30 to the extent that the thermal conductivity and other physical properties thereof are not overly compromised. For example, a solvent or other diluent may be employed during the compounding of the binder 34 in order to lower the viscosity thereof and improve the mixing and application/delivery of the material. Pigments, flame retardants, and antioxidants also may be added depending upon the particular application envisioned.

Turning next to Figure 3, an alternative arrangement of the conductively-cooled electrical assembly 10 is shown generally at 40. The assembly 40 again includes the heat-generating electronic component 12 which is supported on the printed circuit board 16 via the leads 18a and 18b. In the embodiment 40, however, the component 12 is interposed between the board 16 and a separate thermal dissipation member which is shown at 14' to be a separate heat sink dissipation member. The dissipation member 14' is supported over the component 12, and is shown for purposes of illustration to be configured as a thermally-conductive plate 42, which may be formed of a metal such as aluminum or other material having a relatively high heat capacity and other thermal dissipation properties.

As before, the component 12 is supported above the board 16 such that an external heat transfer surface, 20', of the component 12 is spaced-apart from an opposing surface, 22', of the plate 42. A gap, represented at 24' as being of a predetermined width, 26', is thereby defined between the component 12 and the plate 42. The thermally-conductive, electrically-insulating interlayer 30 is disposed within the gap 24' in conductive heat transfer contact with the surface 20' of the component 12 and the opposing surface 22' of the plate 42. Again, the interlayer 30 at least partially fills the gap 24' to provide a conductive path therethrough for the transfer of thermal energy from the component 12 to the plate 42. The gap 24 between the surface 20 of the component 12 and the surface 22 of the board 16 may be left unfilled further to assist the conductive cooling of the component 12. Alternatively, the gap 24 may be filled, as was described in connection with Figure 1, with a second interlayer 30 (not shown) to provide a second conductive heat transfer path from the component 12.

The interlayer 30 may be incorporated with the assemblies 10 or 40 as being formed from a layer of a curable composition which is applied in a fluent state to the surface 22 of the board 16 (Figure 1) prior to the mounting of the component 12 thereon, or to the surface 20' of the component 12 (Figure 3) prior to the disposition of the component 12 in a spaced-apart adjacency from the heat sink plate 42. In both of the described variations, the applied layer of the curable composition may be cured either prior to assembly or, after assembly, in situ within the gap 24 (Figure 1) or 24' (Figure 3). By "cured," it is meant that the binder of the composition is polymerized, cross-linked, further cross-linked or polymerized, vulcanized, cooled, hardened, or otherwise chemically or physically changed from a liquid or other fluent into a solid resin, elastomeric, or other polymeric phase.

Alternatively, the interlayer 30 may be provided as being formed from a layer of a curable composition which is injected or extruded in a fluent state into the gap 24 of the assembly 10 (Figure 1), or the gap 24' of the assembly 10 (Figure 3), wherein which it is cured in situ. In all of the above-described variations, it will be appreciated that the interlayer 30 is cured-in-place on either a surface of the component 12 or the thermal dissipation member 14 or 14', or in situ between the component 12 and the thermal dissipation member 14 or 14'. In this regard, the necessity to pre-form the interface material as a sheet or pad, and then to apply the material to the component or dissipation member as separate steps is obviated. Moreover, waste generation is reduced with the present flashless process as compared to die cut or moulding processes. Such a cure-in-place process additionally is less labour intensive as being amenable to a more automated operation.

In a preferred embodiment, the thermally-conductive interlayer is provided as formed-in-place from a curable composition which comprises a binder of an RTV silicone elastomer loaded with about 50-55wt% of graphitic boron nitride (BN) filler particles. The BN filler is selected as having a thermal conductivity of about 25-50 W/m-°K, and is milled or otherwise processed to have a maximum particle size distribution of at least about 3 mils (75 microns) and, desirably, at least about 5 mils (125 microns). Suitable RTV silicones are marketed commercially by Dow Coming Corp (Midland, MI), General Electric Co (Silicone Products Div., Pittsfield, MA), and Shinetsu Corp. (Torrance, CA). Preferably, the silicone binder is provided as a two-part formulation of two reactive components and a platinum catalyst.

Suitable BN fillers are marketed commercially by Advanced Ceramic Corp. (Cleveland, OH). The filler is available as a mixture which contains a particle size distribution of 14-15 mils (355-380 microns) maximum, 8-9 mils average (200-230 microns), and 3-4 mils (75-100 microns) fines. Each of the reactive components is pre-mixed with the BN fillers particles using a planetary mixer or the like. The components then are separately passed through a 3-roll mill or the like to reduce the particle size of the filler to about a 4-5 mil (100-125 microns) maximum. In this regard, the rolls of the mill are set to have a gap of about 5 mils (125 microns) therebetween to achieve the characteristic controlled particle size. This is to be contrasted with a conventional milling process which would reduce the size of the filler down to elementary particles of about a 1-1.5 mil (25-40 microns) maximum.

After compounding, the components may be stored for later reactive processing using a hand-held caulking gun, which may be of a cartridge-fed, static-mixer variety, or, alternatively, using automated injection equipment such as a robotic applicator. Immediately prior to application, the components are admixed and then delivered as a reactive mixture to a surface of the electrical assembly wherein the mixture is cured-in-place to form the thermally-conductive interlayer. To reduce the cycle time, the curing may be effected at an elevated temperature to accelerate the vulcanization reaction. The components alternatively may be pre-mixed and then frozen for storage. To facilitate mixing and application, it is preferred that the admixture is formulated to have a viscosity of about 300,000 cp. It has been empirically observed that the relatively larger filler particle size of the composition achieves fluent viscosities at higher filler loading proportions, e.g., 50-55wt%, as compared to the compositions heretofore known in the art which are characteristically loaded at 35-40wt%. Moreover, as the graphitic BN filler of the preferred embodiment may be considered a lubricant relative to the abrasive oxide fillers common in conventional formulations, improved tool life is realized for the mixing, metering, and delivery equipment which may be employed.

As an alternative to the above-described 2-part RTV system, a one-part system may be provided as comprising, for example, a hydrolyzable polyfunctional silane or siloxane which is activated by atmospheric moisture. In whatever form the silicone-based system is provided, due to the affinity of the silicone polymer for most surfaces, excellent adhesion of the cured material to substrates may be realized without the use of primers or the like. If desired, however, a primer such as a functionalized silane, silicate ester, cyanurate, or the like may be used.

The Example to follow, wherein all percentages and proportions are by weight unless otherwise expressly indicated, is illustrative of the practising of the invention herein involved, but should not be construed in any limiting sense.

### EXAMPLE

A two-part, RTV silicone-based curable composition for forming the thermally-conductive, electrically-insulative interlayer was compounded as is set forth in Table 1:

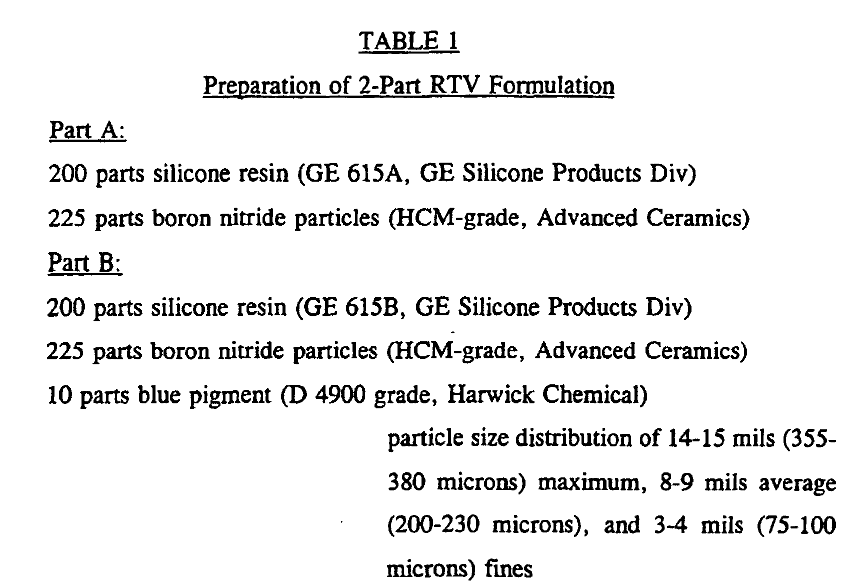

Each of Parts A and B was prepared in a Ross double planetary mixer (Charles Ross & Sons) by premixing the BN filler into the silicone resin until homogeneous. The pre-mixed components were then separately passed through a Ross three roll mill (Charles Ross & Sons). The rolls of the mill were set as having a gap spacing of about 5 mils in order to effect the reduction of the filler to about a 4-5 mil (100-125 mil) maximum.

Formulated as described, the Part A and B components then were loaded into a syringe-or caulking-type gun (Charles Ross & Sons) having a static mixing nozzle and a dual piston displacement set for a mix ratio of 10:1 by volume of A:B, i.e., 38 cc Part A to 3.8 cc Part B. A quantity of the mixed material was delivered from the gun and cured at room temperature for 48 hours. The following physical properties are representative of the cured composition, and confirm the suitability thereof for the intended application:

**TABLE 2**

| **Representative Physical Properties** | |
|---|---|
| Volume Resistivity | 10¹³Ω-cm |
| Dielectric Strength | 500 VAC/mil |
| Hardness | 70 Shore A |
| Thermal Conductivity | 1.2 W/m-°K |
| Specific Gravity | 1.50 |

## Claims

1. A method of conductively cooling a heat-generating electronic component (12) disposable in spaced-apart adjacency with a surface (22,22') of a thermal dissipation member (14,14') to define a gap (24,24') of predetermined width (26,26') therebetween, said method comprising the steps of:
(a) providing a curable composition comprising an electrically-insulating polymeric binder having thermally-conductive, electrically-insulating filler particles (36a-h) dispersed therein, at least a portion (36a-b) of said particles (36a-h) being of a maximum average diameter (38) about equal to the predetermined width of the gap (24,24'),
(b) providing a layer of said composition disposable in conductive heat transfer contact with the electronic component (12) and the surface (22,22') of the thermal dissipation member (14,14'), and
(c) curing said layer of said composition to form an interlayer (30) within the gap (24,24'), at least a portion of said filler particles (36a-b) of said maximum average diameter (38) each substantially directly contacting the electronic component (12) and the surface (22,22') of the thermal dissipation member (14,14') to establish thermally-conductive pathways effective to transfer heat from the electronic component (12) to the heat dissipation member (14,14').

2. A method according to claim 1, wherein the thermal dissipation member is a heat sink (14') or a circuit board (14).

3. A method according to claim 1, wherein said layer of said composition is provided in step (b) as applied on the surface of the thermal dissipation member (14,14'), and wherein said method further comprises an additional step after step (b) of disposing said electronic component (12) on said layer.

4. A method according to claim 1, wherein said layer of said composition is provided in step (b) as applied to an outer surface of said electronic component (12), and wherein said method further comprises an additional step after step (b) of disposing said thermal dissipation member (14') on said layer.

5. A method according to claim 1, further comprising an additional step prior to step (b) of disposing the electronic component (12) in said spaced-apart adjacency with the surface of the thermal dissipation member (14,14'), and wherein said layer is provided in step (b) as interposed between said electronic component (12) and the surface of the thermal dissipation member (14,14').

6. A method according to claim 1, wherein said curable composition is provided in step (a) as comprising a first and a second reactive component each containing a portion of said filler particles (36a-h), said method further comprising an additional step prior to step (b) of admixing said first and said second reactive component.

7. A method according to claim 6, wherein said first reactive component comprises a silanol-terminated polymer and said second reactive component comprises a cross-linking agent, said reactive components combining when admixed to form a room-temperature vulcanizing (RTV) silicone elastomer forming said polymeric binder of said composition.

8. A method according to claim 6, further comprising an additional step prior to step (b) of disposing the electronic component (12) in said spaced-apart adjacency with the surface of the thermal dissipation member (14,14'), and wherein said layer is provided in step (b) by injecting the admixed first and second reactive components between the electronic component (12) and the surface of the thermal dissipation member (14,14').

9. A method according to claim 1, wherein said filler particles (36a-h) of said curable composition are selected from the group consisting of particles of boron nitride, aluminum oxide, aluminum nitride, magnesium oxide, zinc oxide, silicon carbide, beryllium oxide, and mixtures thereof.

10. A method according to claim 1, wherein said filler particles (36a-h) comprise graphitic boron nitride.

11. A method according to claim 1, wherein said polymeric binder of said curable composition is selected from the group consisting of polyurethanes, polyimides, nylons, polyamides, polyesters, polyolefins, epoxies, polyetheretherketones, silicone elastomers, fluorosilicone elastomers, thermoplastic elastomers, acrylic resins, and copolymers and blends thereof.

12. A method according to claim 1, wherein said polymeric binder of said curable composition comprises a room temperature vulcanizing (RTV) silicone elastomer.

13. A method according to claim 1, wherein said curable composition is provided as comprising about 50 to 55% by weight of said filler particles (36a-h).

14. A method according to claim 1, wherein the width of the gap (24,24') between the electronic component and the surface of the thermal dissipation member (14,14') is at least about 3 mils (75 microns).

15. A method according to claim 1, wherein the average diameter of the portion (36a-b) of said particles (36a-h) of said curable composition provided as having a maximum average diameter (38) substantially equal to the predetermined width of the gap (24,24') is at least about 5 mils (125 microns).

16. A conductively-cooled electrical assembly (10) comprising:
a thermal dissipation member (14,14') having an outer surface (22,22');
a heat-generating electronic component (12) disposed in spaced-apart adjacency with said surface (22,22') of said thermal dissipation member (14,14') to define a gap (24,24') of predetermined width (26,26') therebetween; and
a cured-in-place interlayer (30) disposed within said gap (24,24') in conductive heat transfer contact with said electronic component (12) and the surface (22,22') of said thermal dissipation member (14,14'), said interlayer (30) comprising an electrically-insulating polymeric binder with thermally-conductive, electrically-insulating filler particles (30a-h) dispersed therein, at least a portion (30a-b) of said particles being of a maximum average diameter (38) about equal to the predetermined width (26,26') of the gap (24,24') and substantially directly contacting said electronic component (12) and the surface (22,22') of said thermal dissipation member (14,14') to establish heat transfer pathways from said electronic component (12) to said thermal dissipation member (14,14').

17. An electrical assembly according to claim 16, wherein said thermal dissipation member is a heat sink (14') or a circuit board (14).

18. An electrical assembly according to claim 16, wherein said filler particles (36a-h) of said interlayer (30) are selected from the group consisting of particles of boron nitride, aluminum oxide, aluminum nitride, magnesium oxide, zinc oxide, silicon carbide, beryllium oxide, and mixtures thereof.

19. An electrical assembly according to claim 16, wherein said filler particles (36a-h) of said interlayer (30) comprise graphitic boron nitride.

20. An electrical assembly according to claim 16, wherein said polymeric binder of said interlayer (30) is selected from the group consisting of polyurethanes, polyimides, nylons, polyamides, polyesters, polyolefins, epoxies, polyetheretherketones, silicon elastomers, fluorosilicon elastomers, thermoplastic elastomers, acrylic resins, and copolymers and blends thereof.

21. An electrical assembly according to claim 16, wherein said polymeric binder of said interlayer (30) comprises a room temperature vulcanizing (RTV) silicon elastomer.

22. An electrical assembly according to claim 16, wherein said interlayer (30) comprises about 50 to 55% by weight of said filler particles (36a-h).

23. An electrical assembly according to claim 16, wherein the width (26,26') of said gap (24,24') between said electronic component (12) and the surface (22,22') of said thermal dissipation member (14,14') is at least about 3 mils (75 microns).

24. An electrical assembly according to claim 16, wherein the average diameter of the portion (36a-b) of said particles (36a-h) of said interlayer (30) having a maximum average diameter substantially equal to the predetermined width (26,26') of said gap (24,24') is at least about 5 mils (125 microns).

## Patentansprüche

1. Verfahren zur leitenden Kühlung eines wärmeerzeugenden elektronischen Bauteils (12), das in beabstandeter Nachbarschaft zu einer Fläche (22, 22') eines Wärmeableiters (14, 14') angeordnet werden kann, um dazwischen einen Spalt (24, 24') mit vorbestimmter Breite (26, 26') zu definieren, wobei dieses Verfahren die Schritte umfasst des:
(a) Vorsehens einer aushärtbaren Zusammensetzung, die ein elektrisch isolierendes Polymerbindemittel umfasst, das wärmeleitende, elektrisch isolierende Füllstoffpartikel (36a-h) aufweist, die darin zerstreut sind, wobei mindestens ein Anteil (36a-b) dieser Partikel (36a-h) einen maximalen durchschnittlichen Durchmesser (38) aufweist, der etwa der vorbestimmten Breite des Spalts (24, 24') entspricht,
(b) Vorsehens einer Schicht dieser Zusammensetzung, die mit dem elektronischen Bauteil (12) und der Fläche (22, 22') des Wärmeableiters (14, 14') im leitenden Wärmeübertragungskontakt angeordnet werden kann, und
(c) Aushärtens dieser Schicht dieser Zusammensetzung, um im Inneren des Spalts (24, 24') eine Zwischenschicht (30) auszubilden, wobei mindestens ein Anteil der Füllstoffpartikel (36a-b) mit dem maximalen durchschnittlichen Durchmesser (38) jeweils im wesentlichen direkt mit dem elektronischen Bauteil (12) und der Fläche (22, 22') des Wärmeableiters (14, 14') in Kontakt ist, um Wärmeleitwege herzustellen, die zur Wärmeübertragung vom elektronischen Bauteil (12) zum Wärmeableiter (14, 14') wirksam sind.

2. Verfahren nach Anspruch 1, wobei der Wärmeableiter ein Kühlkörper (14') oder eine Leiterplatte (14) ist.

3. Verfahren nach Anspruch 1, wobei in Schritt (b) die Schicht der Zusammensetzung vorgesehen wird, indem sie auf die Fläche des Wärmeableiters (14, 14') aufgetragen wird, und wobei das Verfahren nach Schritt (b) darüber hinaus einen zusätzlichen Schritt des Anordnens des elektronischen Bauteils (12) auf dieser Schicht umfasst.

4. Verfahren nach Anspruch 1, wobei in Schritt (b) die Schicht der Zusammensetzung vorgesehen wird, indem sie auf eine Außenfläche des elektronischen Bauteils (12) aufgetragen wird, und wobei das Verfahren nach Schritt (b) darüber hinaus einen zusätzlichen Schritt des Anordnens des Wärmeableiters (14') auf dieser Schicht umfasst.

5. Verfahren nach Anspruch 1, außerdem umfassend einen zusätzlichen Schritt, vor Schritt (b), des Anordnens des elektronischen Bauteils (12) in beabstandeter Nachbarschaft zur Fläche des Wärmeableiters (14, 14'), und wobei die in Schritt (b) vorgesehene Schicht zwischen dem elektronischen Bauteil (12) und der Fläche des Wärmeableiters (14, 14') angeordnet wird.

6. Verfahren nach Anspruch 1, wobei die in Schritt (a) vorgesehene aushärtbare Zusammensetzung eine erste und eine zweite reaktive Komponente umfasst, die jeweils einen Anteil der Füllstoffpartikel (36a-h) enthalten, und das Verfahren darüber hinaus vor Schritt (b) einen zusätzlichen Schritt des Mischens der ersten und zweiten reaktiven Komponente umfasst.

7. Verfahren nach Anspruch 6, wobei die erste reaktive Komponente ein mit Silanol abgeschlossenes Polymer und die zweite reaktive Komponente ein Vernetzungsmittel enthält, wobei diese reaktiven Komponenten sich bei ihrer Vermischung miteinander verbinden, um ein bei Raumtemperatur vulkanisierendes (RTV) Siliconelastomer zu ergeben, das das Polymerbindemittel der Zusammensetzung bildet.

8. Verfahren nach Anspruch 6, außerdem umfassend einen zusätzlichen Schritt, vor Schritt (b), des Anordnens des elektronischen Bauteils (12) in der beabstandeten Nachbarschaft zur Fläche des Wärmeableiters (14, 14'), und wobei die Schicht in Schritt (b) vorgesehen wird, indem die vermischte erste und zweite reaktive Komponente zwischen dem elektronischen Bauteil (12) und der Fläche des Wärmeableiters (14, 14') eingespritzt wird.

9. Verfahren nach Anspruch 1, wobei die Füllstoffpartikel (36a-h) der aushärtbaren Zusammensetzung aus der Gruppe der Partikel aus Bornitrid, Aluminiumoxid, Aluminiumnitrid, Magnesiumoxid, Zinkoxid, Siliziumcarbid, Berylliumoxid und Mischungen davon gewählt werden.

10. Verfahren nach Anspruch 1, wobei die Füllstoffpartikel (36a-h) graphithaltiges Bornitrid enthalten.

11. Verfahren nach Anspruch 1, wobei das Polymerbindemittel der aushärtbaren Zusammensetzung aus der Gruppe der Polyurethane, Polyimide, Nylone, Polyamide, Polyester, Polyolefine, Epoxide, Polyetheretherketone, Siliconelastomere, Fluorsiliconelastomere, thermoplastischen Elastomere, Acrylharze und Copolymere und Mischungen davon gewählt wird.

12. Verfahren nach Anspruch 1, wobei das Polymerbindemittel der aushärtbaren Zusammensetzung ein bei Raumtemperatur vulkanisierendes (RTV) Siliconelastomer enthält.

13. Verfahren nach Anspruch 1, wobei die aushärtbare Zusammensetzung etwa 50 bis 55 Gewichtsprozent Füllstoffpartikel (36a-h) enthält.

14. Verfahren nach Anspruch 1, wobei die Breite des Spalts (24, 24') zwischen dem elektronischen Bauteil und der Fläche des Wärmeableiters (14, 14') mindestens etwa 3/1000 Zoll (75 Mikron) beträgt.

15. Verfahren nach Anspruch 1, wobei der durchschnittliche Durchmesser des Anteils (36a-b) der Partikel (36a-h) in der aushärtbaren Zusammensetzung, der einen maximalen durchschnittlichen Durchmesser (38) aufweist, der im wesentlichen der vorbestimmten Breite des Spalts (24, 24') entspricht, mindestens etwa 5/1000 Zoll (125 Mikron) beträgt.

16. Leitend gekühlte elektrische Baugruppe (10), umfassend:
einen Wärmeableiter (14, 14'), der eine Außenfläche (22, 22') aufweist;
ein wärmeerzeugendes elektronisches Bauteil (12), das in beabstandeter Nachbarschaft zu dieser Fläche (22, 22') des Wärmeableiters (14, 14') angeordnet ist, um dazwischen einen Spalt (24, 24') mit vorbestimmter Breite (26, 26') zu definieren; und
eine vor Ort ausgehärtete Zwischenschicht (30), die im Inneren des Spalts (24, 24') in leitendem Wärmeübertragungskontakt mit dem elektronischen Bauteil (12) und der Fläche (22, 22') des Wärmeableiters (14, 14') angeordnet ist, wobei diese Zwischenschicht (30) ein elektrisch isolierendes Polymerbindemittel mit wärmeleitenden, elektrisch isolierenden Füllstoffpartikeln (30a-h) enthält, die darin zerstreut sind, und mindestens ein Anteil (30a-b) dieser Partikel einen maximalen durchschnittlichen Durchmesser (38) aufweist, der etwa der vorbestimmten Breite (26, 26') des Spalts (24, 24') entspricht und im wesentlichen mit dem elektronischen Bauteil (12) und der Fläche (22, 22') des Wärmeableiters (14, 14') direkt in Kontakt ist, um Wärmeleitwege vom elektronischen Bauteil (12) zum Wärmeableiter (14, 14') herzustellen.

17. Elektrische Baugruppe nach Anspruch 16, wobei der Wärmeableiter ein Kühlkörper (14') oder eine Leiterplatte (14) ist.

18. Elektrische Baugruppe nach Anspruch 16, wobei die Füllstoffpartikel (36a-h) der aushärtbaren Zusammensetzung aus der Gruppe der Partikel aus Bornitrid, Aluminiumoxid, Aluminiumnitrid, Magnesiumoxid, Zinkoxid, Siliziumcarbid, Berylliumoxid und Mischungen davon gewählt sind.

19. Elektrische Baugruppe nach Anspruch 16, wobei die Füllstoffpartikel (36a-h) graphithaltiges Bornitrid enthalten.

20. Elektrische Baugruppe nach Anspruch 16, wobei das Polymerbindemittel der Zwischenschicht (30) aus der Gruppe der Polyurethane, Polyimide, Nylone, Polyamide, Polyester, Polyolefine, Epoxide, Polyetheretherketone, Siliconelastomere, Fluorsiliconelastomere, thermoplastischen Elastomere, Acrylharze und Copolymere und Mischungen davon gewählt ist.

21. Elektrische Baugruppe nach Anspruch 16, wobei das Polymerbindemittel der Zwischenschicht (30) ein bei Raumtemperatur vulkanisierendes (RTV) Siliconelastomer enthält.

22. Elektrische Baugruppe nach Anspruch 16, wobei die Zwischenschicht (30) etwa 50 bis 55 Gewichtsprozent Füllstoffpartikel (36a-h) enthält.

23. Elektrische Baugruppe nach Anspruch 16, wobei die Breite (26, 26') des Spalts (24, 24') zwischen dem elektronischen Bauteil (12) und der Fläche (22, 22') des Wärmeableiters (14, 14') mindestens etwa 3/1000 Zoll (75 Mikron) beträgt.

24. Elektrische Baugruppe nach Anspruch 16, wobei der durchschnittliche Durchmesser des Anteils (36a-b) der Partikel (36a-h) der Zwischenschicht (30), der einen maximalen durchschnittlichen Durchmesser aufweist, der im wesentlichen der vorbestimmten Breite (26, 26') des Spalts (24, 24') entspricht, mindestens etwa 5/1000 Zoll (125 Mikron) beträgt.

## Revendications

1. Procédé de refroidissement par conduction d'un composant électronique thermogène (12) pouvant être placé dans une adjacence d'espacement avec une surface (22,22') d'un élément de dissipation thermique (14,14') afin de définir un espace (24,24') d'une largeur prédéterminée (26,26') intermédiaire, ledit procédé comprenant les étapes consistant à : (a) créer une composition durcissable comprenant un liant polymère diélectrique ayant des particules de remplissage diélectriques thermoconductrices (36a à 36h) dispersées à l'intérieur de celui-ci, au moins une partie (36a, 36b) desdites particules (36a à 36h) présentant un diamètre moyen maximum (38) environ égal à la largeur prédéterminée de l'espace (24,24'). (b) créer une couche de ladite composition pouvant être placée en contact par échange conductif avec le composant électronique (12) et la surface (22,22') de l'élément de dissipation thermique (14,14') et
(c) durcir ladite couche de ladite composition afin de former une couche intermédiaire (30) à l'intérieur de l'espace (24,24'), au moins une partie desdites particules de remplissage (36a, 36b) dudit diamètre moyen maximum (38) étant sensiblement en contact direct avec le composant électronique (12) et la surface (22,22') de l'élément de dissipation thermique (14,14'), afin d'élaborer des voies thermoconductrices efficaces pour transférer la chaleur depuis le composant électronique (12) vers l'élément de dissipation thermique (14,14').

2. Procédé selon la revendication 1, dans lequel l'élément de dissipation thermique est un dissipateur thermique (14') ou une carte de circuit imprimé (14).

3. Procédé selon la revendication 1, dans lequel ladite couche de ladite composition est créée lors de l'étape (b), lorsqu'elle est appliquée sur la surface de l'élément de dissipation thermique (14,14'), et dans lequel ledit procédé comprend également une étape supplémentaire postérieure à l'étape (b) consistant à placer ledit composant électronique (12) sur ladite couche.

4. Procédé selon la revendication 1, dans lequel ladite couche de ladite composition est formée lors de l'étape (b) lorsqu'elle est appliquée à une surface externe dudit composant électronique (12), et dans lequel ledit procédé comprend également une étape supplémentaire postérieure à l'étape (b) consistant à placer ledit élément de dissipation thermique (14') sur ladite couche.

5. Procédé selon la revendication 1, comprenant également une étape supplémentaire antérieure à l'étape (b) consistant à placer le composant électronique (12) dans ladite adjacence d'espacement avec la surface de l'élément de dissipation thermique (14,14'), et dans lequel procédé ladite couche est créée lors de l'étape (b), lorsqu'elle est intercalée entre ledit composant électronique (12) et la surface de l'élément de dissipation thermique (14,14').

6. Procédé selon la revendication 1, dans lequel ladite composition durcissable est créée lors de l'étape (a), laquelle composition comprend un premier et un deuxième composants réactifs comprenant chacun une partie desdites particules de remplissage (36a à 36h), lequel procédé comprend également une étape supplémentaire antérieure à l'étape (b) consistant à mélanger lesdits premier et deuxième composants réactifs.

7. Procédé selon la revendication 6, dans lequel ledit premier composant réactif comprend un polymère doté d'une terminaisons silanol et ledit deuxième composant réactif comprend un agent de réticulation, lesdits composants réactifs se combinant lorsqu'ils sont mélangés afin de former un élastomère de silicone obtenu par vulcanisation à température ambiante (RTV), lequel élastomère forme ledit liant polymère de ladite composition.

8. Procédé selon la revendication 6, comprenant également une étape supplémentaire antérieure à l'étape (b) consistant à placer le composant électronique (12) dans ladite adjacence d'espacement avec la surface de l'élément de dissipation thermique (14,14'), et dans lequel procédé ladite couche est créée lors de l'étape (b) en introduisant les premier et deuxième composants réactifs mélangés entre le composant électronique (12) et la surface de l'élément de dissipation thermique (14,14').

9. Procédé selon la revendication 1, dans lequel lesdites particules de remplissage (36a à 36h) de ladite composition durcissable sont choisies dans le groupe comprenant les particules de nitrure de bore, d'oxyde d'aluminium, de nitrure d'aluminium, d'oxyde de magnésium, d'oxyde de zinc, de carbure de silicium, d'oxyde de béryllium, et les mélanges de ceux-ci.

10. Procédé selon la revendication 1, dans lequel lesdites particules de remplissage (36a à 36h) comprennent du nitrure de bore graphitique.

11. Procédé selon la revendication 1, dans lequel ledit liant polymère de ladite composition durcissable est choisi dans le groupe comprenant les polyuréthanes, les polyimides, les nylons, les polyamides, les polyesters, les polyoléfines, les époxies, les polyétheréthercétones, les élastomères de silicone, les élastomères de fluorosilicone, les élastomères thermoplastiques, les résines acryliques et les copolymères et mélanges de ceux-ci.

12. Procédé selon la revendication 1, dans lequel ledit liant polymère de ladite composition durcissable comprend un élastomère de silicone obtenu par vulcanisation à température ambiante (RTV).

13. Procédé selon la revendication 1, dans lequel ladite composition durcissable est formée et comprend environ 50 à 55 % en poids desdites particules de remplissage (36a à 36h).

14. Procédé selon la revendication 1, dans lequel la largeur de l'espace (24,24') entre le composant électronique et la surface de l'élément de dissipation thermique (14,14') est d'au moins 3 mils environ (75 microns).

15. Procédé selon la revendication 1, dans lequel le diamètre moyen de la partie (36a à 36b) desdites particules (36a à 36h) de ladite composition durcissable formée et présentant un diamètre moyen maximum (38) sensiblement égal à la largeur prédéterminée de l'espace (24,24') est d'au moins 5 mils environ (125 microns).

16. Equipement électrique refroidi par conduction (10) comprenant :
un élément de dissipation thermique (14,14') ayant une surface externe (22,22') ;
un composant électronique thermogène (12) placé dans une adjacence d'espacement avec ladite surface (22,22') dudit élément de dissipation thermique (14,14') afin de définir un espace (24,24') d'une largeur prédéterminée (26,26') intermédiaire ;
et une couche intermédiaire durcie sur place (30) disposée à l'intérieur de l'espace (24,24') en contact par échange conductif avec ledit composant électronique (12) et la surface (22,22') dudit élément de dissipation thermique (14,14'), ladite couche intermédiaire (30) comprenant un liant polymère diélectrique doté de particules de remplissage diélectriques thermoconductrices (30a à 30h) dispersées à l'intérieur de celui-ci, au moins une partie (30a, 30b) desdites particules ayant un diamètre moyen maximum (38) environ égal à la largeur prédéterminée (26,26') de l'espace (24,24') et sensiblement en contact direct avec ledit composant électronique (12) et la surface (22,22') dudit élément de dissipation thermique (14,14'), afin de créer des voies de transfert thermique depuis le composant électronique (12) vers ledit élément de dissipation thermique (14,14').

17. Equipement électrique selon la revendication 16, dans lequel ledit élément de dissipation thermique est un dissipateur thermique (14') ou une carte de circuit imprimé (14).

18. Equipement électrique selon la revendication 16, dans lequel lesdites particules de remplissage (36a à 36h) de ladite couche intermédiaire (30) sont choisies dans le groupe comprenant les particules de nitrure de bore, d'oxyde d'aluminium, de nitrure d'aluminium, d'oxyde de magnésium, d'oxyde de zinc, de carbure de silicium, d'oxyde de béryllium, et les mélanges de celles-ci.

19. Equipement électrique selon la revendication 16, dans lequel lesdites particules de remplissage (36a à 36h) de ladite couche intermédiaire (30) comprennent du nitrure de bore graphitique.

20. Equipement électrique selon la revendication 16, dans lequel ledit liant polymère de ladite couche intermédiaire (30) est choisi dans le groupe comprenant les polyuréthanes, les polyimides, les nylons, les polyamides, les polyesters, les polyoléfines, les époxies, les polyétheréthercétones, les élastomères de silicone, les élastomères de fluorosilicone, les élastomères thermoplastiques, les résines acryliques et les copolymères et mélanges de ceux-ci.

21. Equipement électrique selon la revendication 16, dans lequel ledit liant polymère de ladite couche intermédiaire (30) comprend un élastomère de silicone obtenu par vulcanisation à température ambiante (RTV).

22. Equipement électrique selon la revendication 16, dans lequel ladite couche intermédiaire (30) comprend environ 50 à 55 % en poids desdites particules de remplissage (36a à 36h).

23. Equipement électrique selon la revendication 16, dans lequel la largeur (26,26') dudit espace (24,24') entre le composant électronique (12) et la surface (22,22') dudit élément de dissipation thermique (14,14') est d'au moins 3 mils environ (75 microns).

24. Equipement électrique selon la revendication 16, dans lequel le diamètre moyen de la partie (36a à 36b) desdites particules (36a à 36h) de ladite couche intermédiaire (30) ayant un diamètre moyen maximum sensiblement égal à la largeur prédéterminée (26,26') dudit espace (24,24') est d'au moins 5 mils environ (125 microns).
